# EUROPEAN PATENT SPECIFICATION

(11) **EP 2 341 504 B1**
(45) Date of publication and mention of the grant of the patent: **14.03.2012**
(21) Application number: 09180423.7
(22) Date of filing: 22.12.2009
(51) Int. Cl.: G11C 5/00

(54) **Memory chips and judgment circuits thereof**
Speicherchips und Beurteilungsschaltung daraus
Puces de mémoire et leurs circuits de jugement

(43) Date of publication of application: 06.07.2011
(73) Proprietor: Winbond Electronic Corp., Taichung County 428 (TW)
(72) Inventor: Tu, Ying-Te, 807, Kaohsiung City (TW)
(74) Representative: Mehler, Klaus

(56) References cited:
- US-A- 4 987 325
- US-B1- 6 225 836

## Description

### BACKGROUND OF THE INVENTION

### Field of the Invention

The invention relates to a memory chip, and more particularly to a judgment circuit for judging that a memory chip is operating as a single memory die or one among stacked memory dies according to statuses of an option pad of the memory chip.

### Description of the Related Art

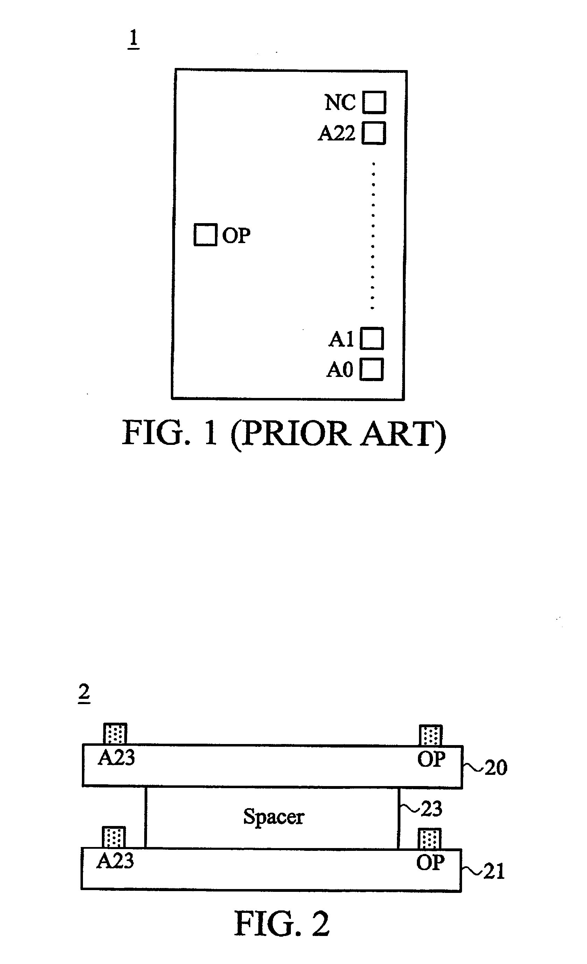

FIG. 1 is a schematic view showing a 256Mb memory chip. Referring to FIG. 1, the memory chip 1 comprises 23 address pads A0∼A22, an option pad OP, and a dummy pad NC. When the memory chip 1 operates as a single memory die, both of the option pad OP and the dummy pad NC are floating. A weak pulling high/low circuit on the inside of the memory chip 1 gradually pulls an internal node which is connected with the option pad OP to a high/low voltage level. In the following description, a weak pulling high circuit and a weak pulling high operation for the option pad OP are given as an example.

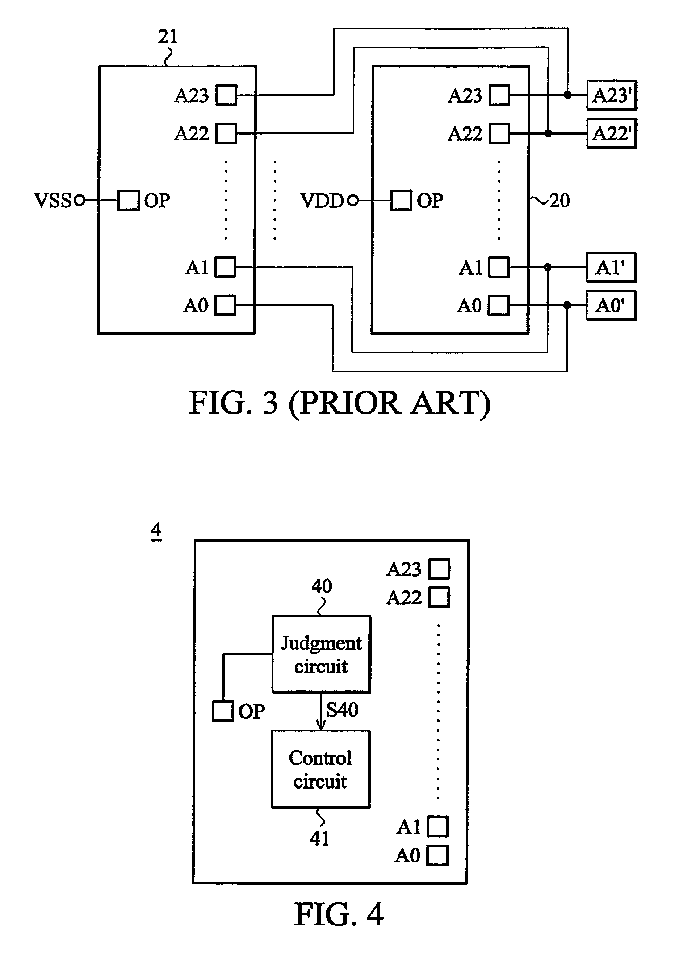

In some applications, at least two memory chips 1, as shown in FIG. 1, can be stacked to form a memory device. As shown in FIG. 2, a 512Mb memory device 2 having two stacked memory chips 20 and 21 of 256Mb is given as an example. Each of the stacked memory chips 20 and 21 has the same structure as the memory chip 1 of FIG. 1, and the dummy pad NC of the memory chip 1 serves as the 24^{th} address pad A23 for addressing the two memory chips 20 and 21. The top memory chip 20 is stacked on the bottom memory chip 21, and a spacer 23 is therebetween. FIG. 3 is a schematic view showing connection between the address pads A0∼A23 of the memory chips 20 and 21. In order to clearly show the connection, the memory chips 20 and 21 are shown side by side, and, however, in practice, the top memory chip 20 is stacked on the bottom memory chip 21, as shown in FIG. 2. Referring to FIG. 3, the address pads A0∼A23 of the memory chip 20 are connected to the address pads A0∼A23 of the memory chip 21 at address pads A0'∼A23' respectively. The memory chips 20 and 21 receive an address signal through the address pads A0'∼A23'.

In FIG. 3, the option pad OP of the top memory chip 20 is tied to a high voltage source VDD, and an internal node connected to the option pad OP thereof is thus at a high level. The option pad OP of the bottom memory chip 21 is tied to a low voltage source VSS, and an internal node connected to the option pad OP thereof is thus at a low voltage level. Thus, when the address pad A23' receives a logic high signal (H), the top memory chip 20 is activated and the bottom memory chip 21 is inactivated. Contrarily, when the address pad A23' receives a low signal (L), the bottom memory chip 21 is activated and the top memory chip 20 is inactivated.

Thus, one memory chip, such as the memory chips 20 and 21, can operate at three modes according to the status of its option pad. At the first mode, the memory chip operates as a single memory die when the option pad OP thereof is floating; at the second mode, the memory chip operates as a top memory die among two stacked memory dies when the option pad OP thereof is tied to the high voltage source VDD; and at the third mode, the memory chip operates as a bottom memory die among two stacked memory dies when the option pad OP thereof is tied to the voltage source VSS. At the three modes, the internal node connected to the option pad OP of the memory chip is weakly pulled high, strongly pulled high, and strongly pulled low respectively. According to the above description, when one memory chip operates at the first mode and the second mode, an internal node connected to an option pad OP of the memory chip is pulled high. Thus, when the internal node is at a high level, the memory chip itself can not determine that it is operating as a single memory die (first mode) or as a top memory die among two stacked memory dies (second mode). This situation may occur to one memory chip desiring to be a top memory die among two stacked memory dies, such as the top memory chip 20 in FIG. 2.

Assume that a weak pulling low circuit and a weak pulling low operation are applied for floating of the option pad OP. According to the above description, when one memory chip operates at the first mode and the third mode, an internal node connected to an option pad OP of the memory chip is pulled low. Thus, when the internal node is at a low voltage level, the memory chip itself can not determine that it is operating as a single memory die (first mode) or as a bottom memory die among two stacked memory dies (third mode). This situation may occur to one memory chip desiring to be a bottom memory chip among two stacked memory dies, such as the bottom memory chip 21 in FIG. 2.

Thus, it is desired to provide a judgment circuit for judging that a memory chip is operating as a single memory die or one among stacked memory dies.

The chips as disclosed in US 6,225,836 and US 4,987,325 have mode direction circuits that discriminate between two modes.

### BRIEF SUMMARY OF THE INVENTION

An exemplary embodiment of a memory chip is provided. The memory chip operates at a plurality of modes. The memory chip comprises an option pad and a detection unit. The option pad has a plurality of statuses. The detection unit is coupled to the option pad at a first node and is controlled by a control signal to generate a detection signal according to the current status of the option pad. The detection unit comprises a weak pulling high element coupled between a high level voltage source and the first node. It further comprises a switch element which is coupled between the first node and a ground voltage source and is turned on by the asserted control signal. Therein, the switch element momentarily pulls a potential of the option node to a level of the ground voltage source when the control signal is asserted and the detection signal is generated at the first node. The memory chip further comprises a sampling unit for receiving the detection signal and sampling the detection signal twice after the control signal has been deasserted to generate a judgment signal, wherein the judgment signal indicates in which mode the memory chip is operating.

A detailed description is given in the following embodiments with reference to the accompanying drawings.

### BRIEF DESCRIPTION OF the DRAWINGS

The invention can be more fully understood by reading the subsequent detailed description and examples with references made to the accompanying drawings, wherein:

FIG. 1 is a schematic view showing a memory chip;

FIG. 2 shows a memory device having two stacked memory chips;

FIG. 3 is a schematic view showing connection between the address pads A0∼A23 of the memory chips 20 and 21 in FIG. 2;

FIG. 4 shows an exemplary embodiment of a memory chip;

FIG. 5 shows an exemplary embodiment of the judgment circuit 40 in FIG. 4;

FIG. 6 shows an exemplary embodiment of the detection unit 50 in FIG. 5;

FIG. 7a shows wave forms of the voltage of the voltage source VCC (VS2), the control signal CS, and the detection signal S60 and the logic values of the judgment signal S40 when the memory chip 4 is operating as a single memory die (the first mode) in the embodiment of FIG. 6;

FIG. 7b shows wave forms of the voltage of the voltage source VCC (VS2), the control signal CS, and the detection signal S60 when the memory chip 4 is operating as a top memory die among two stacked memory dies (the second mode) in the embodiment of FIG. 6;

FIG. 7c shows wave forms of the voltage of the voltage source VCC (VS2), the control signal CS, and the detection signal S60 when the memory chip 4 is operating as a bottom memory die among two stacked memory dies (the third mode) in the embodiment of FIG. 6;

FIG. 8 shows another exemplary embodiment of the detection unit 50 in FIG. 5;

FIG. 9a shows wave forms of the voltage of the voltage source VCC (VS1), the control signal CS, and the detection signal S60 and the logic values of the judgment signal S40 when the memory chip 4 is operating as a single memory die (the first mode) in the embodiment of FIG. 8;

FIG. 9b shows wave forms of the voltage of the voltage source VCC (VS1), the control signal CS, and the detection signal S60 when the memory chip 4 is operating as a top memory die among two stacked memory dies (the second mode) in the embodiment of FIG. 8;

FIG. 9c shows wave forms of the voltage of the voltage source VCC (VS1), the control signal CS, and the detection signal S60 when the memory chip 4 is operating as a bottom memory die among two stacked memory dies (the third mode) in the embodiment of FIG. 8;

FIG. 10 shows another exemplary embodiment of the detection unit 50 in FIG. 5;

FIG. 11 a shows wave forms of the voltage of the voltage source VCC (VS2), the control signal CS, and the detection signals S90 and S991, the state of the switch element 91, and the logic values of the judgment signal S40 when the memory chip 4 is operating as a single memory die (the first mode) in the embodiment of FIG. 10;

FIG. 11b shows wave forms of the voltage of the voltage source VCC (VS2), the control signal CS, and the detection signals S90 and S91, the state of the switch element 91, and the logic values of the judgment signal S40 when the memory chip 4 is operating as a top memory die among two stacked memory dies (the second mode) in the embodiment of FIG. 10;

FIG. 11c shows wave forms of the voltage of the voltage source VCC (VS2), the control signal CS, and the detection signals S90 and S91, the state of the switch element 91, and the logic values of the judgment signal S40 when the memory chip 4 is operating as a bottom memory die among two stacked memory dies (the third mode) in the embodiment of FIG. 10;

FIG. 12 shows another exemplary embodiment of the detection unit 50 in FIG. 5;

FIG. 13a shows wave forms of the voltage of the voltage source VCC (VS1), the control signal CS, and the detection signals S90 and S91, the state of the switch element 91, and the logic values of the judgment signal S40 when the memory chip 4 is operating as a single memory die (the first mode) in the embodiment of FIG. 12;

FIG. 13b shows wave forms of the voltage of the voltage source VCC (VS1), the control signal CS, and the detection signals S90 and S91, the state of the switch element 91, and the logic values of the judgment signal S40 when the memory chip 4 is operating as a top memory die among two stacked memory dies (the second mode) in the embodiment of FIG. 12; and

FIG. 13c shows wave forms of the voltage of the voltage source VCC (VS1), the control signal CS, and the detection signals S90 and S91, the state of the switch element 91, and the logic values of the judgment signal S40 when the memory chip 4 is operating as a bottom memory die among two stacked memory dies (the third mode) in the embodiment of FIG. 12.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

Memory chips are provided. In an exemplary embodiment of a memory chip in FIG. 4, a memory chip 4 comprises a plurality of address pads, an option pad OP, a judgment circuit 40, and a control circuit 41. The option pad OP has different statuses. In the embodiment, the option pad OP has three statuses: a floating status, a strong high status, and a strong low status respectively in the three modes. For example, when the option pad OP is floating, the option pad OP is at the floating status. When the option pad OP is tied to a high voltage source VDD, the option pad OP is at the strong high status. When the option pad OP is tied to a low voltage source VSS, the option pad OP is at the strong low status. In the embodiment, the memory chip 4 is a 256Mb memory chip. Since the memory chip 4 can operate as one memory die among two stacked memory dies of 512Mb in some applications, the memory chip 4 comprises 24 address pads A0∼A23. In other embodiments, the number of address pads of a memory chip is determined according the size of the memory chip.

The judgment circuit 40 is coupled to the option pad OP and generates a judgment signal S40 according to the current status of the option pad OP. Thus, the judgment signal S40 indicates which mode the memory chip 4 is operating at. The control circuit 41 receives the judgment signal S40 and controls the memory chip 4 according to the judgment signal S40. In the embodiment, when the option pad OP is at the floating status, the judgment circuit 40 generates the judgment signal S40 to indicate that the memory chip 4 operates as a single memory die at a first mode. When the option pad OP is at the strong high status, the judgment circuit 40 generates the judgment signal S40 to indicate that the memory chip 4 operates as a top memory die among two stacked memory dies at a second mode. When the option pad OP is at the strong low status, the judgment circuit 40 generates the judgment signal S40 to indicate that the memory chip 4 operates as a bottom memory die among two stacked memory dies at a third mode.

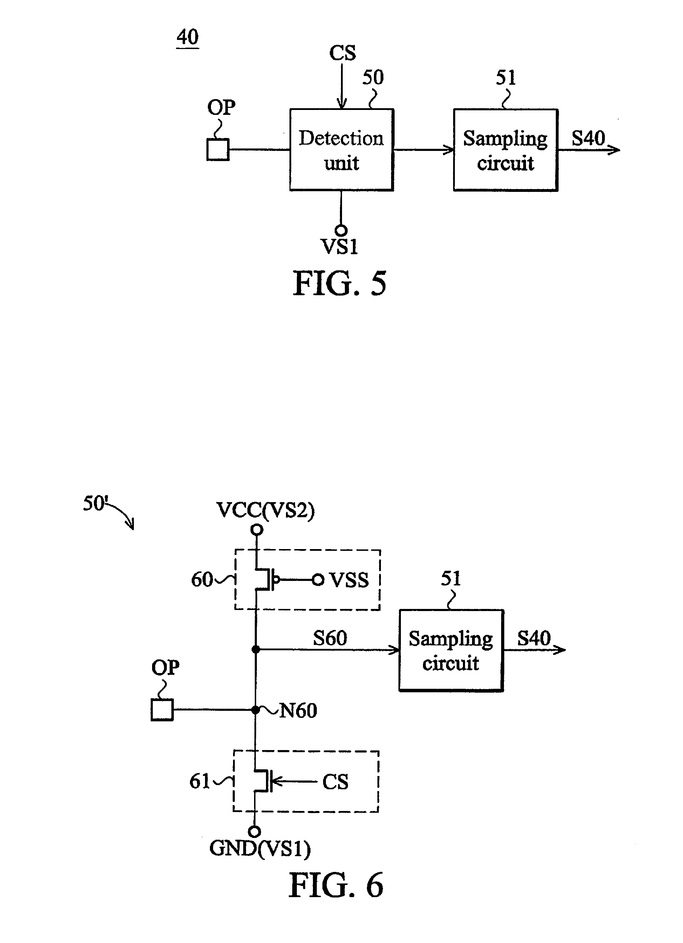

FIG. 5 shows an exemplary embodiment of the judgment circuit 40 in FIG. 4. Referring to FIG. 5, the judgment circuit 40 comprises a detection unit 50 and a sampling unit 51. The detection unit 50 is coupled to a voltage source VS1 and the option pad OP. The detection unit 50 is controlled by a control signal CS to generate at least one detection signal according to the current status of the option pad OP. When the control signal is asserted, a level of the at least one detection signal is varied by a voltage provided by the voltage source VS 1. The sampling unit 51 receives the at least one detection signal and samples the at least one detection signal after the control signal CS is asserted to generate the judgment signal S40.

FIG. 6 shows an exemplary embodiment of the detection unit 50 in FIG. 5. Referring to FIG. 6, a detection unit 50' is coupled to the option pad OP at a node N60. The detection unit 50' comprises a weak pulling high/low element 60 and a switch element 61. The weak pulling high/low element 60 is coupled between a voltage source VS2 and the node N60. The switch element 61 is coupled between the node N60 and the voltage source VS1 and turned on by the asserted control signal CS. Assume that when the memory chip 4 is operating as a single memory die, that is the memory chip 4 is operating at the first mode, the option pad OP is floating, and the node N60 connected with the option pad OP is weakly pulled high to a high level. Thus, the voltage source VS1 would provide, a low level voltage, such as a ground voltage GND, and the voltage source VS2 would provide a high level voltage, such as an operation voltage VCC. Assume also that in this situation, the weak pulling high/low element 60 is implemented by a PMOS transistor which is always turned on by a low voltage source VSS, and the PMOS transistor has a long channel length. Additionally, the switch element 61 is implemented by an NMOS transistor and turned on according to the asserted control signal CS with a high level. In the embodiment, one detection signal S60 is generated at the node N60 to be sampled by the sampling unit 51.

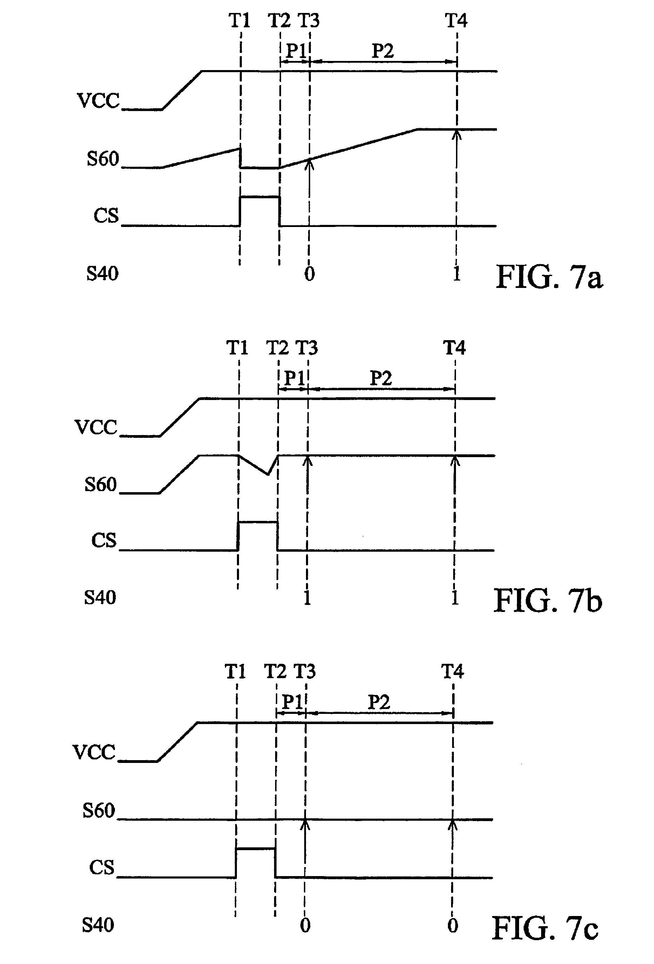

FIG. 7a shows wave forms of the voltage of the voltage source VCC (VS2), the control signal CS, and the detection signal S60 and the logic values of the judgment signal S40 when the memory chip 4 is operating as a single memory die (the first mode). As described above, when the memory chip 4 operates as a single memory die, the option pad OP is floating. Referring to FIG. 7a, the level of the detection signal S60 is gradually pulled high with the high level voltage VCC of the voltage source VS2. At a time point T1, the control signal CS is switched to a high level from a low level, that is the control signal CS is asserted. The switch element 61 is turned on according to the asserted control signal CS with the high level at the time point T1. Thus, the detection signal S60 is pulled low immediately to the level of the low level voltage GND of the voltage source VS 1. The detection signal S60 is continuously at the level of the low level voltage GND of the voltage source VS1 until the control signal CS is switched to the low level from the high level at a time point T2 (i.e. the control signal CS is de-asserted at the time point T2) to turn off the switch element 61. In other words, the detection signal S60 is continuously at the level of the low level voltage GND of the voltage source VS1 when the control signal CS is asserted from the time point T1 to the time point T2. After the time point T2, the detection signal S60 is gradually pulled high with the high level voltage VCC of the voltage source VS2 again. At a time point T3 after the control signal CS is de-asserted for a short period P1, the sampling unit 51 samples the detection signal S60 to obtain a first logic value "0" due to the detection signal S60 being gradually pulled higher from a low level. After the time point T3 for a long period P2, the sampling unit 51 samples the detection signal S60 again to obtain a second logic value at a time point T4. Since the detection signal S60 is at the level of the high level voltage VCC of the voltage source VS2 at the time point T4, the second logic value is logic "1". The first logic value "0" and the second logic value "1" form the judgment signal S40.

According to the description in reference to FIG. 7a, when the memory chip 4 operates as a single memory die, the judgment circuit 40 generates the judgment signal S40 of "01" according to the floating status of the option pad OP.

FIG. 7b shows wave forms of the voltage of the voltage source VCC (VS2), the control signal CS, and the detection signal S60 and the logic values of the judgment signal S40 when the memory chip 4 is operating as a top memory die among two stacked memory dies (the second mode). At the second mode, the option pad OP is tied to the high voltage source VDD. According to the above description, the control signal CS is asserted between the time points T1 and T2, and the sampling unit 51 samples the detection signal S60 twice at the time points T3 and T4 to obtain a first logic value and a second logic value respectively. As shown in FIG. 7b, at the second mode, the first logic value "1" and the second logic value "1" form the judgment signal S40. According to the description in reference to FIG. 7b, when the memory chip 4 operates as a top memory die among two stacked memory dies, the judgment circuit 40 generates the judgment signal S40 of "11" according to the strong high status of the option pad OP.

FIG. 7c shows wave forms of the voltage of the voltage source VCC (VS2), the control signal CS, and the detection signal S60 and the logic values of the judgment signal S40 when the memory chip 4 is operating as a bottom memory die among two stacked memory dies (the third mode). At the third mode, the option pad OP is tied to the low voltage source VSS. According to the above description, the control signal CS is asserted between the time points T1 and T2, and the sampling unit 51 samples the detection signal S60 twice at the time points T3 and T4 to obtain a first logic value and a second logic value respectively. As shown in FIG. 7c, at the third mode, the first logic value "0" and the second logic value "0" form the judgment signal S40. According to the description in reference to FIG. 7c, when the memory chip 4 operates as a bottom memory die among two stacked memory dies, the judgment circuit 40 generates the judgment signal S40 of "00" according to the strong low status of the option pad OP.

In the above embodiment of FIG. 6, when the memory chip 4 operates as a single memory die (the first mode), the option pad OP is floating, and the node N60 connected with the option pad OP is weakly pulled high. In some embodiments, when the memory chip 4 operates as a single memory die (the first mode), the option pad OP is floating, and the node N60 connected with the option pad OP is weakly pulled low.

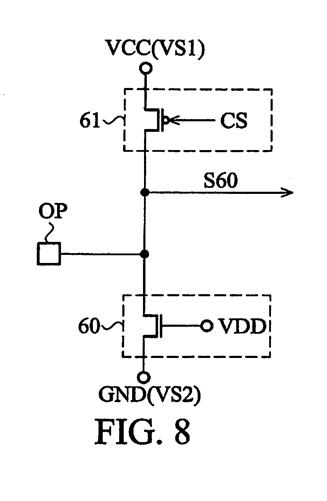

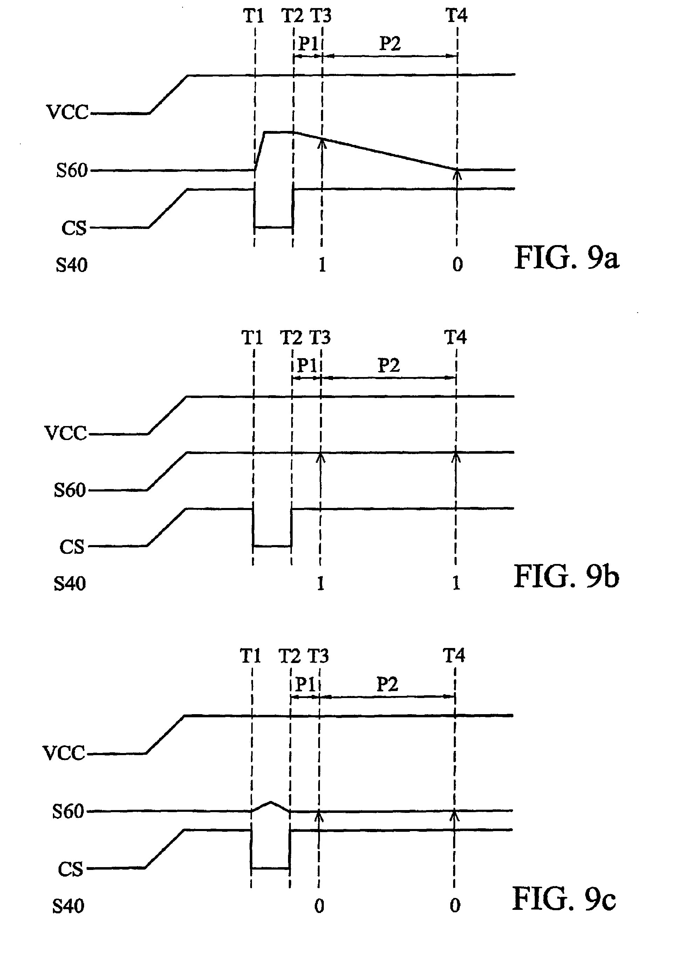

Thus, the voltage source VS1 provides a high level voltage, such as an operation voltage VCC, and the voltage source VS2 provides a low level voltage, such as a ground voltage GND, as show in FIG. 8. In this situation, the weak pulling high/low element 60 is implemented by an NMOS transistor which is always turned on by a high voltage source VDD, and the NMOS transistor has a long channel length. The switch element 61 is implemented by a PMOS transistor and turned on according to the asserted control signal CS with a low level. According to the timing of the control signal CS and the sampling operation of the sampling unit 51 as shown in FIGs. 9a∼9c, the sampling unit 51 of the judgment circuit 40 can generate the judgment signal S40 indicating which mode the memory chip 4 is operating at according to the statuses of the option pad OP. Specifically, the judgment signal S40 can clearly indicate whether the memory chip 4 is operating as a single memory die (the first mode) or as a bottom memory die among two stacked memory dies (the third mode). Note that at both of the first and third modes, the node N60 connected with the option pad OP is eventually pulled to a low level.

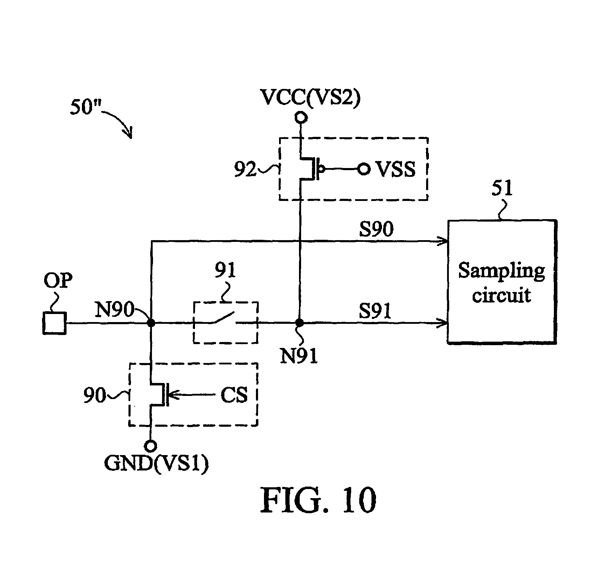

FIG. 10 shows another exemplary embodiment of the detection unit 50 in FIG. 5. Referring to FIG. 10, a detection unit 50" is coupled to the option pad OP at a node N90. The detection unit 50" comprises switch elements 90 and 91 and a weak pulling high/low element 92. The switch element 90 is coupled between the node N90 and the voltage source VS1 and turned on by the asserted control signal CS. The switch element 91 is coupled between the node N90 and a node N91. The weak pulling high/low element 92 is coupled between a voltage source VS2 and the node N91. Assume that when the memory chip 4 operates as a single memory die, that is the memory chip 4 operates at the first mode, the option pad OP is floating, and the node N90 connected with the option pad OP is weakly pulled higher to a high level. Thus, the voltage source VS1 would provide a low level voltage, such as a ground voltage GND, and the voltage source VS2 would provide a high level voltage, such as an operation voltage VCC. Assume also that, in this situation, the weak pulling high/low element 92 is implemented by a PMOS transistor which is always turned on by a low voltage source VSS, and the PMOS transistor has a long channel length. Additionally, the switch element 90 is implemented by an NMOS transistor and turned on according to the asserted control signal CS with a high level. In the embodiment, one detection signal S90 is generated at the node N90, and the other detection signal S91 is generated at the node N91. The detection signals S90 and S91 are sampled by the sampling unit 51.

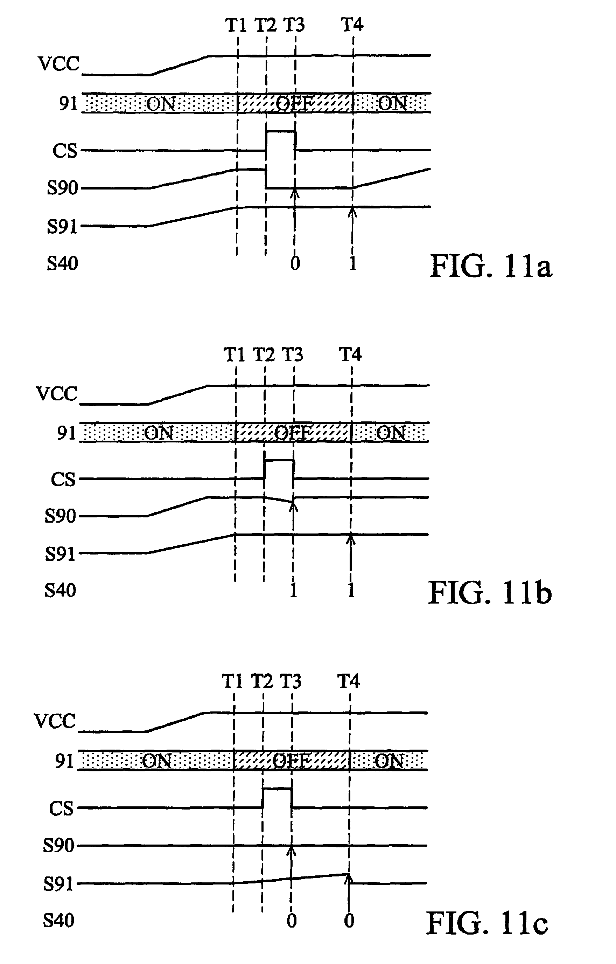

FIG. 11a shows wave forms of the voltage of the voltage source VCC (VS2), the control signal CS, and the detection signals S90 and S91, the state of the switch element 91, and the logic values of the judgment signal S40 when the memory chip 4 is operating as a single memory die (the first mode). As described above, when the memory chip 4 operates as a single memory die, the option pad OP is floating. Referring to FIG. 11a, the switch element 91 is turned on in the period before a time point T1. The levels of the detection signals S90 and S91 are gradually pulled high with the high level voltage VCC of the voltage source VS2 and reach the level of the high level voltage VCC before the time point T1. At time point T1, the switch element 91 is turned off. The detection signal S90 is continuously at the level of the high level voltage VCC until the control signal CS is switched to a high level from a low level at a time point T2 (i.e. the control signal CS is asserted at the time point T2) to turn on the switch element 90. At the time point T2, since the control signal CS is asserted, the detection signal S90 is pulled low immediately to the level of the low level voltage GND of the voltage source VS1. At a time point T3, the control signal CS is switched to the low level from the high level (i.e. the control signal CS is de-asserted at the time point T3) to turn off the switch element 90. At this time, since the switch element 91 is still turned off, the detection signal S90 is not pulled high with the high level voltage VCC, and the detection signal S90 is continuously at the level of the low level voltage GND of the voltage source VS1. The sampling unit 51 samples the detection signal S90 at the time point T3 (after the control signal CS is asserted) to obtain a first logic value "0". At a time point T4, the switch element 91 is turned on. Due to the turned-on switch element 91, the level of the detection signal S90 is gradually pulled high with the high level voltage VCC. Moreover, as shown in FIG. 11a, in the period between the time points T1 and T4, since the switch element 91 is turned off, the detection signal S91 is not affected by the low level voltage GND, and the detection signal S91 is continuously at the level of the high level voltage VCC. The sampling unit 51 samples the detection signal S91 at the time point T4 to obtain a second logic value "1". The first logic value "0" and the second logic value "1" form the judgment signal S40.

According to the description in reference to FIG. 11a, when the memory chip 4 operates as a single memory die, the judgment circuit 40 generates the judgment signal S40 of "01" according to the floating status of the option pad OP.

FIG. 11b shows wave forms of the voltage of the voltage source VCC (VS2), the control signal CS, and the detection signals S90 and S91, the state of the switch element 91, and the logic values of the judgment signal S40 when the memory chip 4 is operating as a top memory die among two stacked memory dies (the second mode). At the second mode, the option pad OP is tied to the high voltage source VDD. According to the above description, the control signal CS is asserted between the time points T2 and T3, the state switching of the switch element 91 occurs at the time points T1 and T4, and the sampling unit 51 samples the detection signals S90 and S91 at the time points T3 and T4 to obtain a first logic value and a second logic value respectively. As shown in FIG. 11b, at the second mode, the first logic value "1" and the second logic value "1" form the judgment signal S40. According to the description in reference to FIG. 111b, when the memory chip 4 operates as a top memory die among two stacked memory dies, the judgment circuit 40 generates the judgment signal S40 of "11" according to the strong high status of the option pad OP.

FIG. 11c shows wave forms of the voltage of the voltage source VCC (VS2), the control signal CS, and the detection signals S90 and S91, the state of the switch element 91, and the logic values of the judgment signal S40 when the memory chip 4 is operating as a bottom memory die among two stacked memory dies (the third mode). At the third mode, the option pad OP is tied to the low voltage source VSS. According to the above description, the control signal CS is asserted between the time points T2 and T3, occurs at the time points T1 and T4, and the state switching of the switch element 91, and the sampling unit 51 samples the detection signal S60 twice at the time points T3 and T4 to obtain a first logic value and a second logic value respectively. As shown in FIG. 11c, at the second mode, the first logic value "0" and the second logic value "0" form the judgment signal S40. According to the description in reference to FIG. 11c, when the memory chip 4 operates as a bottom memory die among two stacked memory dies, the judgment circuit 40 generates the judgment signal S40 of "00" according to the strong low status of the option pad OP.

According to the above embodiment, the sampling unit 51 of the judgment circuit 40 can generate the judgment signal S40 indicating which mode the memory chip 4 is operating at according to the statuses of the option pad OP. Specifically, the judgment signal S40 can clearly indicate whether the memory chip 4 is operating as a single memory die (the first mode) or as a top memory die among two stacked memory dies (the second mode). Note that at both of the first and second modes, the node N90 connected with the option pad OP is eventually pulled to a high level.

In the above embodiment of FIG. 10, when the memory chip 4 operates as a single memory die (the first mode), the option pad OP is floating, and the node N90 connected with the option pad OP is weakly pulled high. In some embodiments, when the memory chip 4 operates as a single memory die (the first mode), the option pad OP is floating, and the node N90 connected with the option pad OP is weakly pulled low.

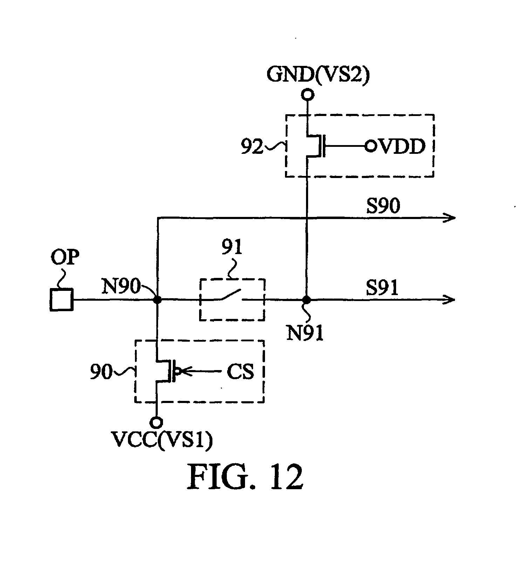

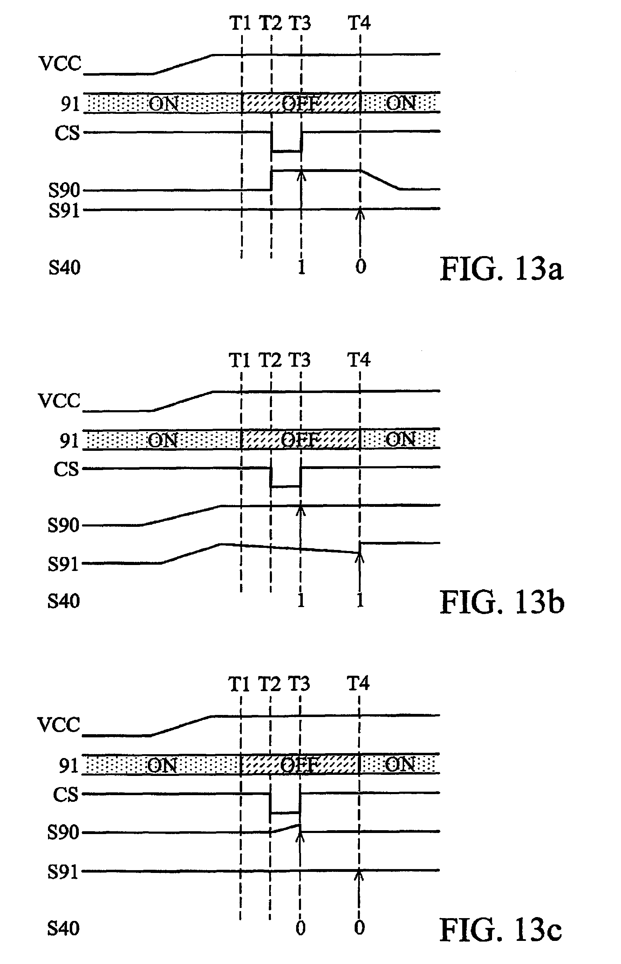

Thus, the voltage source VS1 provides a high level voltage, such as an operation voltage VCC, and the voltage source VS2 provides a low level voltage, such as a ground voltage GND, as show in FIG. 12. In this situation, the weak pulling high/low element 92 is implemented by an NMOS transistor which is always turned on by a high voltage source VDD, and the NMOS transistor has a long channel length. The switch element 90 is implemented by a PMOS transistor and turned on according to the asserted control signal CS with a low level. According to the timing of the control signal CS, the switching operation of the switch element 91, and the sampling operation of the sampling unit 51 as shown in FIGs. 13a∼13c, the sampling unit 51 of the judgment circuit 40 can generate the judgment signal S40 indicating which mode the memory chip 4 is operating at according to the statuses of the option pad OP. Specifically, the judgment signal S40 can clearly indicate whether the memory chip 4 is operating as a single memory die (the first mode) or as a bottom memory die among two stacked memory dies (the third mode). Note that at both of the first and third modes, the node N90 connected with the option pad OP is eventually pulled to a low level.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A memory chip operating at a plurality of modes comprising:
an option pad (OP) having a plurality of statuses; and
a detection unit (50') coupled to the option pad at a first node (N60) and controlled by a control signal (CS) to generate a detection signal (S60) according to the current status of the option pad; wherein the detection unit comprises:
a weak pulling high element (60) coupled between a high level voltage source (Vcc) and the first node (N60); and
a switch element (61) coupled between the first node (N60) and a ground voltage, source (GND) and turned on by the asserted control signal (CS);
wherein the switch element (61) momentarily pulls a potential of the option pad (OP) to a level of the ground voltage source (GND) when the control signal (CS) is asserted, and the detection signal (S61) is generated at the first node (N60); and
a sampling unit (51) for receiving the detection signal (S60) and sampling the detection signal (S60) twice after the control signal (CS) has been deasserted to generate a judgment signal (S40);
wherein the judgment signal (S40) indicates which mode the memory chip is operating at.

2. The memory chip as claimed in claim 1 further comprising a control circuit for receiving the judgment signal and controlling the memory chip according to the judgment signal.

3. The memory chip as claimed in claim 1, wherein the weak pulling high element is implemented by a PMOS transistor which is always turned on.

4. A memory chip operating at a plurality of modes comprising:
an option pad (OP) having a plurality of statuses; and
a detection unit (50') coupled to the option pad at a first node (N60) and controlled by a control signal (CS) to generate a detection signal (S60) according to the current status of the option pad (OP); wherein the detection unit comprises:
a weak pulling low element (60) coupled between a ground voltage source (GND) and the first node; and
a switch element (61) coupled between the first node and a high level voltage source (VCC) and turned on by the asserted control signal (CS);
wherein the switch element (61) momentarily pulls a potential of the option pad (OP) to a level of the high level voltage source (Vcc) when the control signal (CS) is asserted, and the detection signal (S60) is generated at the first node;
a sampling unit (51) for receiving the detection signal (S60) and sampling the detection signal (S60) twice after the control signal (CS) has been deasserted to generate a judgment signal;
wherein the judgment signal indicates which mode the memory chip is operating at.

5. The memory chip as claimed in claim 4 further comprising a control circuit for receiving the judgment signal and controlling the memory chip according to the judgment signal.

6. The memory chip as claimed in claim 4, wherein the weak pulling low element is implemented by an NMOS transistor which is always turned on.

7. A memory chip operating at a plurality of modes comprising:
an option pad (OP) having a plurality of statuses; and
a detection unit (50") coupled to the option pad (OP) at a first node (N90) and controlled by a control signal (CS) to generate a first detection signal (S90) and a second detection signal (S91) according to the current status of the option pad (OP); wherein the detection unit (50'') comprises:
a first switch element (90) coupled between the first node (N90) and a ground voltage source (GND) and turned on by the asserted control signal (CS);
a second switch element (91) coupled between the first node (N90) and a second node (N91), wherein the second switch element (91) is turned on in a first period and turned off in a second period following the first period; and
a weak pulling high element (92) coupled between a high level voltage source (VCC) and the second node (N91);
wherein the first switch element (90) momentarily pulls a potential of the option pad (OP) to a level of the ground voltage source (GND) when the control signal (CS) is asserted during the second period; and
wherein the first detection signal (S90) is generated at the first node (N90), and the second detection signal (S91) is generated at the second node (N91); and a sampling unit (51) for receiving the first (S90) and second (S91) detection signals and
sampling the first (S90) and second (S91) detection signals at different times (T3/T4)
after the control signal (CS) has been deasserted to generate a judgment signal;
wherein the judgment signal indicates which mode the memory chip is operating at.

8. The memory chip as claimed in claim 7, wherein the weak pulling high element is implemented by a PMOS transistor which is always turned on.

9. The memory chip as claimed in claim 7, wherein the control signal is asserted in the second period, and after the control signal is asserted, the sampling unit samples the first detection signal to obtain a first logic value and samples the second detection signal to obtain a second logic value, and the first and second logic values form the judgment signal.

10. A memory chip operating at a plurality of modes comprising:
an option pad (OP) having a plurality of statuses; and
a detection unit (50") coupled to the option pad (OP) at a first node (N90) and controlled by a control signal (CS) to generate a first detection signal (S90) and a second detection signal (S91) according to the current status of the option pad (OP); wherein the detection unit comprises:
a first switch element (90) coupled between the first node (N90) and a high level voltage source (VCC) and turned on by the asserted control signal (CS);
a second switch element (91) coupled between the first node (N90) and a second node (N91), wherein the second switch element (91) is turned on in a first period and turned off in a second period following the first period; and
a weak pulling high element (92) coupled between a ground voltage source (GND) and the second node (N91);
wherein the first switch element (90) momentarily pulls a potential of the option pad (OP) to a level of the high level voltage source (Vcc) when the control signal (CS) is asserted during the second period; and
wherein the first detection signal (S90) is generated at the first node (N90); and the second detection signal (S91) is generated at the second node (N91); and
a sampling unit (51) for receiving the first (S90) and second (S91) detection signals and sampling the first (S90) and second (S91) detection signals at different times (T3/T4) after the control signal (CS) has been deasserted to generate a judgment signal;
wherein the judgment signal indicates which mode the memory chip is operating at.

11. The memory chip as claimed in claim 10, wherein the weak pulling low element is implemented by an NMOS transistor which is always turned on.

12. The memory chip as claimed in claim 10, wherein the control signal is asserted in the second period, and after the control signal is asserted, the sampling unit samples the first detection signal to obtain a first logic value and samples the second detection signal to obtain a second logic value, and the first and second logic values form the judgment signal.

## Patentansprüche

1. Speicherchip, der in einer Vielzahl von Betriebsarten betrieben werden kann, umfassend:
ein Optionspad (OP) mit einer Vielzahl von Statusmöglichkeiten;
eine Detektionseinheit (50'), die an einem ersten Knoten (N60) mit dem Optionspad (OP) gekoppelt ist und von einem Kontrollsignal (CS) geregelt wird, um ein Detektionssignal (S60) entsprechend dem aktuellen Status des Optionspads (OP) zu erzeugen; wobei die Detektionseinheit (50') umfasst:
ein schwach ziehendes Hochelement (60), welches zwischen einer Hochspannungsquelle (VCC) und dem ersten Knoten (N60) gekoppelt ist, und ein Schaltelement (61), welches zwischen dem ersten Knoten (N60) und einer Grundspannungsquelle (GND) gekoppelt ist und durch das gesetzte Kontrollsignal (CS) eingeschaltet wird,
wobei das Schaltelement (61) momentan ein Potential des Optionspads (OP) auf ein Niveau der Grundspannungsquelle (GND) zieht, wenn das Kontrollsignal (CS) gesetzt ist, und das Detektionssignal (CS) am ersten Knoten (N60) erzeugt wird, und
eine Abfrageeinheit (51) zum Empfangen des Detektionssignals (S60) und zum zweimaligen Abfragen des Defiektionssignals (S60), nachdem das Kontrollsignal (CS) deaktiviert wurde, um ein Beurteilungssignaf (S40) zu erzeugen, wobei das Beurteilungssignal (S40) angibt, in welcher Betriebsart der Speicherchip betrieben wird.

2. Speicherchip nach Anspruch 1, weiterhin umfassend einen Regelungskreis zum Empfangen des Beurteilungssignals (S40) und zum Regeln des Speicherchips entsprechend dem Beurteilungssignal (S40).

3. Speicherchip nach Anspruch 1, wobei das schwach ziehende Hochelement (60) als PMOS implementiert ist, der immer eingeschaltet ist.

4. Speicherchip, der in einer Vielzahl von Betriebsweisen betrieben wird, umfassend:
ein Optionspad (OP) mit einer Vielzahl von Statusmöglichkeiten; und
eine Detektionseinheit (50'), die an einem ersten Knoten (N60) mit dem Optionspad (OP) gekoppelt ist und von einem Kontrollsignal (CS) geregelt wird, um ein Detektionssignal (S60) entsprechend dem aktuellen Status des Optionspads (OP) zu erzeugen; wobei die Detektionseinheit umfasst:
ein schwach ziehendes Niedrigelement (60), welches zwischen einer Grundspannungsquelle (GND) und dem ersten Knoten (N60) gekoppelt ist, und
ein Schaltelement (61), welches zwischen dem ersten Knoten (N60) und einer Hochspannungsquelle (VCC) gekoppelt ist und durch das gesetzte Kontrollsignal (CS) eingeschaltet wird,
wobei das Schaltelement (61) momentan ein Potential des Optionspads (OP) auf ein Niveau der Hochspannungsquelle (VCC) zieht, wenn das Kontrollsignal (CS) gesetzt ist, und das Detektionssignal (CS) am ersten Knoten (N60) erzeugt wird, und
eine Abfrageeinheit (51) zum Empfangen des Detektionssignals (S60) und zum zweimaligen Abfragen des Detektionssignals (S60), nachdem das Kontrollsignal (CS) deaktiviert wurde, um ein Beurteilungssignal (S40) zu erzeugen, wobei das Beurteüungssigna! (S40) angibt, in welcher Betriebsart der Speicherchip betrieben wird.

5. Speicherchip nach Anspruch 4, weiterhin umfassend einen Regelungskreis zum Empfangen des Beurteilungssignals (CS) und zum Regeln des Speicherchips entsprechend dem Beurteilungssignal (S40).

6. Speicherchip nach Anspruch 1, wobei das schwach ziehende Hochelement (60) als NMOS implementiert ist, der immer eingeschaltet ist.

7. Speicherchip, der in einer Vielzahl von Betriebsweisen betrieben wird, umfassend:
ein Optionspad (OP) mit einer Vielzahl von Statusmöglichkeiten; und
eine Detektionseinheit (50"), die an einem ersten Knoten (N90) mit dem Optionspad (OP) gekoppelt ist und von einem Kontrollsignal (CS) geregelt wird, um ein erstes Detektionssignal (S90) und ein zweites Detektionssignal (S91) entsprechend dem aktuellen Status des Optionspads (OP) zu erzeugen; wobei die Detektionseinheit (50") umfasst:
ein erstes Schaltelement (90), welches zwischen dem ersten Knoten (N90) und einer Grundspannungsquelle (GND) gekoppelt ist und durch das gesetzte Kontrollsignal (CS) eingeschaltet wird, und
ein zweites Schaltelement (91), welches zwischen dem ersten Knoten (N90) und einem zweiten Knoten (N91) gekoppelt ist, wobei das zweite Schaltelement (91) in einer ersten Periodendauer eingeschaltet und in einer zweiten Periodendauer ausgeschaltet wird, welche der ersten Periodendauer folgt; und
ein schwach ziehendes Hochelement (92), welches zwischen einer Hochspannungsquelle (VCC) und dem zweiten Knoten (N91) gekoppelt ist;
wobei das erste Schaltelement (90) momentan ein Potential des Optionspads (OP) auf ein Niveau der Grundspannungsquelle (GND) zieht, wenn das Kontrollsignal (CS) während der zweiten Periodendauer gesetzt ist;
wobei das erste Detektionssignal (S90) am ersten Knoten (N90) und das zweite Detektionssignal (S91) am zweiten Knoten (N91) erzeugt werden, und
eine Abfrageeinheit (51) zum Empfangen des ersten und des zweiten Detektionssignals (S90, S91) und zum Abfragen des ersten und des zweiten Detektionssignals (S90, S91) zu unterschiedlichen Zeiten (T3/T4), nachdem das Kontrollsignal (CS) zum Erzeugen eines Beurteilungssignals deaktiviert worden ist; wobei das Beurteilungssignal (S40) angibt, in welcher Betriebsart der Speicherchip betrieben wird.

8. Speicherchip nach Anspruch 7, wobei das schwach ziehende Hochelement (60) als PMOS implementiert ist, der immer eingeschaltet ist.

9. Speicherchip nach Anspruch 7, wobei das Kontrollsignal in der zweiten Periodendauer gesetzt wird, und nachdem das Kontrollsignal (CS) gesetzt ist, die Abfrageeinheit (51) das erste Detektionssignal (S90) abfragt, um einen ersten logischen Wert zu erhalten und das zweite Detektionssignal (S91) abfragt, um einen zweiten logischen Wert zu erhalten, und der erste und der zweite logische Wert das Beurteilungssignal bilden.

10. Speicherchip, der in einer Vielzahl von Betriebsweisen betrieben wird, umfassend:
ein Optionspad (OP) mit einer Vielzahl von Statusmöglichkeiten; und
eine Detektionseinheit (50"), die an einem ersten Knoten (N90) mit dem Optionspad (OP) gekoppelt ist und von einem Kontrollsignal (CS) geregelt wird, um ein erstes Detektionssignal (S90) und ein zweites Detektionssignal (S91) entsprechend dem aktuellen Status des Optionspads (OP) zu erzeugen; wobei die Detektionseinheit (50") umfasst:
ein erstes Schaltelement (90), welches zwischen dem ersten Knoten (N90) und einer Hochspannungsquelle (VCC) gekoppelt ist und durch das gesetzte Kontrollsignal (CS) eingeschaltet wird, und
ein zweites Schaltelement (91), welches zwischen dem ersten Knoten (N90) und einem zweiten Knoten (N91) gekoppelt ist, wobei das zweite Schaltelement (91) in einer ersten Periodendauer eingeschaltet und in einer zweiten Periodendauer ausgeschaltet wird, welche der ersten Periodendauer folgt; und
ein schwach ziehendes Hochelement (92), welches zwischen einer Grundspannungsquelle (GND) und dem zweiten Knoten (N91) gekoppelt ist;
wobei das erste Schaltelement (90) momentan ein Potential des Optionspads (OP) auf ein Niveau der Hochspannungsquelle (VCC) zieht,
wenn das Kontrollsignal (CS) während der zweiten Periodendauer gesetzt ist, und
wobei das erste Detektionssignal (S90) am ersten Knoten (N90) und das zweite Detektionssignal (S91) am zweiten Knoten (N91) erzeugt werden; und
eine Abfrageeinheit (51) zum Empfangen des ersten und des zweiten Detektionssignals (S90, S91) und zum Abfragen des ersten und des zweiten Detektionssignals (S90, S91) zu unterschiedlichen Zeiten (T3/T4), nachdem das Kontrollsignal (CS) zum Erzeugen eines Beurteüungssignals deaktiviert worden ist; wobei das Beurteilungssignal (S40) angibt, in welcher Betriebsart der Speicherchip betrieben wird.

11. Speicherchip nach Anspruch 10, wobei das schwach ziehende Hochelement (60) als NMOS implementiert ist, der immer eingeschaltet ist.

12. Speicherchip nach Anspruch 10, wobei das Kontrollsignal (CS) in der zweiten Periodendauer gesetzt ist, und nachdem das Kontrollsignal (CS) gesetzt ist, die Abfrageeinheit (51) das erste Detektionssignal (S90) abfragt, um einen ersten logischen Wert zu erhalten und das zweite Detektionssignal (S91) abfragt, um einen zweiten logischen Wert zu erhalten, und der erste und der zweite logische Wert das Beurteifungssignal bilden.

## Revendications

1. Puce de mémoire fonctionnant dans une pluralité de modes, comprenant :
une plaquette d'option (OP) ayant une pluralité d'états ; et
une unité de détection (50') couplée à la plaquette d'option à un premier noeud (N60) et commandée par un signal de commande (CS) pour générer un signal de détection (S60) en fonction de l'état courant de la plaquette d'option ; l'unité de détection comprenant :
un élément de mise à niveau haut faible (60) couplé entre une source de tension de niveau haut (VCC) et le premier noeud (N60) ; et
un élément de commutation (61) couplé entre le premier noeud (N60) et une source de tension de terre (GND) et rendu passant par le signal de commande (CS) activé ;
l'élément de commutation (61) mettant momentanément un potentiel de la plaquette d'option (OP) au niveau de la source de tension de terre (GND) quand le signal de commande (CS) est activé et le signal de détection (S61) est généré au premier noeud (N60) ; et
une unité d'échantillonnage (51) pour recevoir le signal de détection (S60) et échantillonner le signal de détection (S60) deux fois après que le signal de commande (CS) a été désactivé pour générer un signal de jugement (S40) ;
le signal de jugement (S40) indiquant dans quel mode fonctionne la puce de mémoire.

2. Puce de mémoire selon la revendication 1, comprenant en outre un circuit de commande pour recevoir le signal de jugement et commander la puce de mémoire en fonction du signal de jugement.

3. Puce de mémoire selon la revendication 1, dans laquelle l'élément de mise à niveau haut faible est implémenté par un transistor PMOS qui est toujours passant.

4. Puce de mémoire fonctionnant dans une pluralité de modes, comprenant :
une plaquette d'option (OP) ayant une pluralité d'états ; et
une unité de détection (50') couplée à la plaquette d'option à un premier noeud (N60) et commandée par un signal de commande (CS) pour générer un signal de détection (S60) en fonction de l'état courant de la plaquette d'option (OP) ; l'unité de détection comprenant :
un élément de mise à niveau bas faible (60) couplé entre une source de tension de terre (GND) et le premier noeud ; et
un élément de commutation (61) couplé entre le premier noeud et une source de tension de niveau haut (VCC) et rendu passant par le signal de commande (CS) activé ;
l'élément de commutation (61) mettant momentanément un potentiel de la plaquette d'option (OP) au niveau de la source de tension de niveau haut (VCC) quand le signal de commande (CS) est activé et le signal de détection (S60) est généré au premier noeud ;
une unité d'échantillonnage (51) pour recevoir le signal de détection (S60) et échantillonner le signal de détection (S60) deux fois après que le signal de commande (CS) a été désactivé pour générer un signal de jugement ;
le signal de jugement indiquant dans quel mode fonctionne la puce de mémoire.

5. Puce de mémoire selon la revendication 4, comprenant en outre un circuit de commande pour recevoir le signal de jugement et commander la puce de mémoire en fonction du signal de jugement.

6. Puce de mémoire selon la revendication 4, dans laquelle l'élément de mise à niveau bas faible est implémenté par un transistor NMOS qui est toujours passant.

7. Puce de mémoire fonctionnant dans une pluralité de modes, comprenant :
une plaquette d'option (OP) ayant une pluralité d'états ; et
une unité de détection (50") couplée à la plaquette d'option (OP) à un premier noeud (N90) et
commandée par un signal de commande (CS) pour générer un premier signal de détection (S90) et un second signal de détection (S91) en fonction de l'état courant de la plaquette d'option (OP) ; l'unité de détection (50") comprenant :
un premier élément de commutation (90) couplé entre le premier noeud (N90) et une source de tension de terre (GND) et rendu passant par le signal de commande (CS) activé ;
un second élément de commutation (91) couplé entre le premier noeud (N90) et un second noeud (N91), le second élément de commutation (91) étant rendu passant dans une première période et bloqué dans une seconde période suivant la première période ; et
un élément de mise à niveau haut faible (92) couplé entre une source de tension de niveau haut (VCC) et le second noeud (N91) ;
le premier élément de commutation (90) mettant momentanément un potentiel de la plaquette d'option (OP) au niveau de la source de tension de terre (GND) quand le signal de commande (CS) est activé pendant la seconde période ; et
le premier signal de détection (S90) étant généré au premier noeud (N90) et le second signal de détection (S91) étant généré au second noeud (N91) ; et
une unités d'échantillonnage (51) pour recevoir les premier (S90) et second (S91) signaux de détection et échantillonner les premier (S90) et second (S91) signaux de détection à différents instants (T3/T4) après que le signal de commande (CS) a été désactivé pour générer un signal de jugement ;
le signal de jugement indiquant dans quel mode fonctionne la puce de mémoire.

8. Puce de mémoire selon la revendication 7, dans laquelle l'élément de mise à niveau haut faible est implémenté par un transistor PMOS qui est toujours passant.

9. Puce de mémoire selon la revendication 7, dans laquelle le signal de commande est activé dans la seconde période, et après que le signal de commande a été activé, l'unité d'échantillonnage échantillonne le premier signal de détection pour obtenir une première valeur logique et échantillonne le second signal de détection pour obtenir une seconde valeur logique, et les première et seconde valeurs logiques forment le signal de jugement.

10. Puce de mémoire fonctionnant dans une pluralité de modes, comprenant :
une plaquette d'option (OP) ayant une pluralité d'états ; et
une unité de détection (50") couplée à la plaquette d'option (OP) à un premier noeud (N90) et
commandée par un signal de commande (CS) pour générer un premier signal de détection (S90) et un second signal de détection (S91) en fonction de l'état courant de la plaquette d'option (OP) ; l'unité de détection comprenant :
un premier élément de commutation (90) couplé entre le premier noeud (N90) et une source de tension de niveau haut (VCC) et rendu passant par le signal de commande (CS) activé ;
un second élément de commutation (91) couplé entre le premier noeud (N90) et un second noeud (N91), le second élément de commutation (91) étant rendu passant dans une première période et bloqué dans une seconde période suivant la première période ; et
un élément de mise à niveau bas faible (92) couplé entre une source de tension de terre (GND) et le second noeud (N91) ;
le premier élément de commutation (90) mettant momentanément un potentiel de la plaquette d'option (OP) au niveau de la source de tension de niveau haut (VCC) quand le signal de commande (CS) est activé pendant la seconde période ; et
le premier signal de détection (S90) étant généré au premier noeud (N90) et le second signal de détection (S91) étant généré au second noeud (N91) ; et
une unité d'échantillonnage (51) pour recevoir les premier (S90) et second (S91) signaux de détection et échantillonner les premier (S90) et second (S91) signaux de détection à différents instants (T3/T4) après que le signal de commande (CS) a été désactivé pour générer un signal de jugement ;
le signal de jugement indiquant dans quel mode fonctionne la puce de mémoire.

11. Puce de mémoire selon la revendication 10, dans laquelle l'élément de mise à niveau bas faible est implémenté par un transistor NMOS qui est toujours passant.

12. Puce de mémoire selon la revendication 10, dans laquelle le signal de commande est activé dans la seconde période, et après que le signal de commande a été activé, l'unité d'échantillonnage échantillonne le premier signal de détection pour obtenir une première valeur logique et échantillonne le second signal de détection pour obtenir une seconde valeur logique, et les première et seconde valeurs logiques forment le signal de jugement.
